Europäisches Patentamt

European Patent Office

Office européen des brevets

(11) Publication number: **0 227 965 B1**

# EUROPEAN PATENT SPECIFICATION

(45) Date of publication of patent specification: **19.08.92**   (51) Int. Cl.5: **H01L 27/10**

(21) Application number: **86116625.4**

(22) Date of filing: **29.11.86**

(54) **Method for ion implant programming NMOS read-only memories and NMOS read-only memory obtained thereby.**

(30) Priority: **12.12.85 IT 2318085**

(43) Date of publication of application:
**08.07.87 Bulletin 87/28**

(45) Publication of the grant of the patent:
**19.08.92 Bulletin 92/34**

(84) Designated Contracting States:
**DE FR GB NL**

(56) References cited:
**GB-A- 2 028 581**
**GB-A- 2 157 489**
**US-A- 4 045 811**

**IEEE JOURNAL OF SOLID-STATE CIRCUITS, vol. SC-17, no. 2, April 1982, pages 220-226, New York, US; P.J. TSANG et al.: "Fabrication of high-performance LDDFET's with oxide sidewall-spacer technology"**

(73) Proprietor: **SGS-THOMSON MICROELECTRON-ICS s.r.l.**
**Via C. Olivetti, 2**
**I-20041 Agrate Brianza Milano(IT)**

(72) Inventor: **Cappelletti, Paolo Giuseppe**
**C. so Garibaldi, 104**
**I-20030 Seveso Milan(IT)**
Inventor: **Maggioni, Franco**
**Via 4 Novembre, 6**
**I-22067 Missaglia Como(IT)**

(74) Representative: **Modiano, Guido et al**
**MODIANO, JOSIF, PISANTY & STAUB**
**Modiano & Associati Via Meravigli, 16**
**I-20123 Milano(IT)**

## Description

The present invention relates to a method for ion implant programing NMOS read-only memories and a NMOS memory obtained thereby.

As is known, read-only memories (ROMs) are employed in several applications and therefore represent a relevant field in the solid-state memory market, besides being generally provided inside microprocessors. Such ROMs are produced according to two techniques: either with NAND logic, so as to achieve greater packing, or with NOR logic in order to achieve greater access speed. The production methods for the two types of memory are substantially different. Hereafter, reference will be made only to the production of NOR logic memories, which are in any case the most widespread ones.

The method normally employed for programing read-only memories comprising a matrix of NOR gates including NMOS devices or transistors consists of the ion implanting of boron in the channel of the transistors through a suitable programing mask. In this manner the threshold voltage of some transistors of the matrix, selected by the programing mask, by virtue of the boron implanting, is increased to a value higher than that of the supply voltage. Accordingly these transistors are 'off' during the reading of the memory.

As a program mask, it is possible to employ a special mask, and in this case the ion implant phase can be carried out in an intermediate phase during the fabrication of the transistors, or the active-area mask can be used, and in this case programing is performed during the first phase of the transistor fabrication. However, it is generally preferred to use the programing and implanting during an intermediate phase, since this method, though it requires an additional mask, allows faster delivery times of the finished memories since it is performed during the production process at a much more advanced stage.

However, the trend towards packing electronic devices ever more densely gives rise to problems which prevent the use of this process. Indeed, there are physical limits which prevent the continued use thereof in the future generations of VLSI devices. Scaling rules, indeed, require the reduction of the thickness of the gate oxides and the junction depths; currently, for 2-$\mu$m long transistors, such as those currently in production for VLSI circuits, typical values for the gate oxide thickness and for the junction depth are respectively 300-400 Å (10Å = 1nm) and 0.3-0.4 $\mu$m. On the other hand, the reduction in thickness of the gate oxide imposes an increase of the concentration of boron in the channel required to increase the threshold voltage above the supply voltage, as required for correct programing. On the other hand, as the boron concentration in the channel increases, the breakdown voltage of the drain junction decreases, the latter being already reduced due to the greater curving of the junction.

On the other hand, for the reliable operation of a read-only memory produced with this technology it is necessary for both the threshold voltage and the breakdown voltage to be higher that the supply voltage. This condition currently limits reduction of the thickness of the gate oxide for processes with arsenic junctions and 5 V supply voltages to 300 - 350 Å.

An other method for programming IC memories is disclosed by GB-A-2 157 489. The known British document teaches forming a plurality of NMOS devices with source, drain and channel regions, with the channel regions extending partially between the drain and source regions. Furthermore, said known document teaches forming a heavier doped P-type region at the source-channel junction in advance to the source forming step.

Therefore, the aim of the invention is to provide a method for ion implant programing NMOS read-only memories such as to allow the use of the abovesaid programing technique even for very-large-scale-integration devices even for future generations, according to the current trends.

Within the scope of the above described aim, a particular object of the present invention is to provide a method allowing reduction of the oxide layers thickness to values matching the scale of integration being used, yet assuring the reliable operation of the ROMs thus produced.

Not least object of the present invention is to provide a said method, consisting of single per se already-known and used technological phases, which can be provided with machines and techniques which are common in the electronics industry, so as to have costs which are comparable with those of the known devices.

The above described aim, the objects mentioned and others which will become apparent hereinafter, are achieved by a process for producing NMOS technology read-only memories programed by ion implanting, according to the invention as recited in claim 1.

The present invention also relates to a NMOS read-only memory, programed by ion implanting even in the case of very-large-scale integration, yet maintaining the necessary reliability and safety in operation.

Said NMOS read-only memory, comprising a plurality of NMOS devices, some predetermined ones of which have a high concentration of boron in the channel, is characterized in that it has said high concentration of boron in the channel only proximate to the source junction.

The invention is based on the appreciation that the two requirements regarding the increase of the integration scale and the maintenance of both breakdown and threshold voltages, which hitherto were believed to be conflicting ones as to the thickness of the oxide layer, are related to two different phenomena, in turn depending upon the concentration of boron in two different regions of the channel, so that by doping said channel differentially it is possible to drop below the limits set by the current technology. Particularly by increasing the concentration of boron in the channel only proximate to the source junction it is possible to increase the threshold voltage (or keep it constant as the gate oxide thickness decreases) without reducing the breakdown voltage.

Further characteristics and advantages will become apparent from the description of a number of preferred, but not exclusive, embodiments, explained in detail hereinafter with reference to the accompanying drawings, where:

Fig.1 is a cross section view of a portion of a semiconductor chip in which an NMOS device or transistor is to be produced, in a first phase of the method according to the invention;

Fig. 2 is a cross section view similar to that of Fig.1 in a subsequent production phase;

Fig. 3 is another cross section view, illustrating a third phase of the first example of the method according to the invention;

Fig. 4 is a similar cross section view illustrating a third method phase which is alternative to that of Fig. 3 according to a second example of the inventive method for producing a special device; and

Fig. 5 is a further method phase of the second example, subsequent to the one of Fig. 4.

Hereinafter, two different examples are described of the method according to the invention for ion implant programming (I.I.P.). NMOS read-only memories, in an intermediate phase of the production process thereof. More in detail, both described processes make use of the greater diffusion coefficient of boron with respect to arsenic; however other systems for increasing the concentration of boron in the channel only proximate to the source junction are also within the scope of the inventive concept.

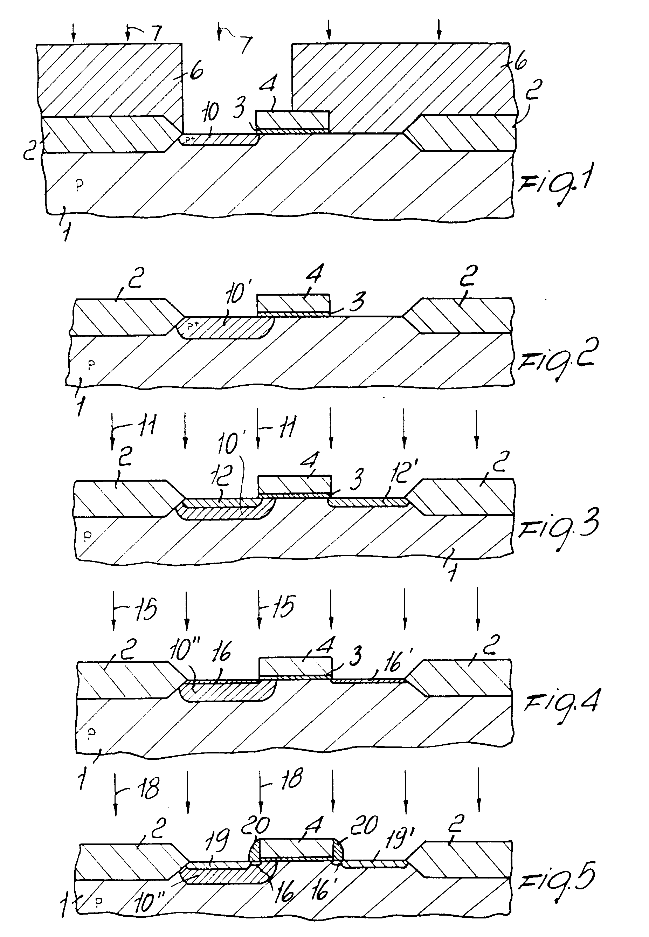

A first example of the method according to the invention is as follows. The conventional NMOS process is performed initially, which process comprises active-zone masking, some implanting maskings, direct contact masking as well as polysilicon masking for defining the gate. In this manner (refer to Fig. 1) an initial structure is obtained which is composed of a P type substrate 1, insulating oxides 2 and 3 and a polysilicon gate region 4. Subsequently, according to the invention, a programing masking step is performed, thereby a mask is obtained, which is open only at the source of the transistor to be programed. This mask is defined in Fig. 1 by the resist layer 6 having an opening at the substrate region which will form the source. Then a programing boron implant is performed (illustrated schematically in Fig. 1 by the arrows 7) so that a thin layer 10 with a high concentration of boron is formed. Then the resist layer 6 is removed and a process is performed at medium-high temperature such as to allow the diffusion of the boron in depth and laterally to achieve the P + type channel region 10' such as to ensure the increase of the threshold voltage above the supply voltage, as is necessary for the correct operation of the device. At the end of this phase, a structure such as illustrated in Fig. 2 will thus be obtained. Subsequently, according to the first example of the method, a heavy arsenic implant is performed at the source and at the drain of the device to be programed. This implant is schematically indicated by the arrows 11 in Fig. 3 and gives rise to the forming of the N type source region 12 and drain region 12'. Then the device is completed by standard NMOS phases, including masking for the contacts, metalization, and passivation.

Instead, if it is desired to obtain devices by means of processes which provide a lightly doped drain (LDD method), the method may be implemented as above explained up to the diffusion of the boron in the channel illustrated in Fig. 2, thereby obtaining the channel layer, indicated at 10" of fig. 4. Subsequently, instead of having a single heavy implant of arsenic on the source and on the drain, this implant is performed in two phases, respectively shown in Figs. 4 and 5. Accordingly, an initial light implant of phosphorus or arsenic is performed, as illustrated in Fig. 4 by the arrows 15, so as to form the source region 16 and the drain region 16' thin and lightly doped, followed by a spacer producing phase. This phase, which is performed in a conventional manner by thermal oxide growth or by chemical vapour deposition and subsequent anisotropic etching without mask, allows to obtain the protection regions 20 at the vertical walls of the gate 4 (see Fig. 5).

Then an implant with a large arsenic dose (arrow 18) is performed to obtain the N type source region 19 and drain region 19'. The process is thus completed in a conventional manner, as described above.

As can be seen from the above description, the invention fully achieves the intended aims. Indeed, a process and a memory are provided which, by virtue of the high concentration of boron at the source junction, has a threshold voltage with a suitable value, while the smaller concentration of boron in the channel at the drain junction keeps the breakdown voltage value high. Accordingly it is possible to reduce the thickness of the gate oxide layer to levels which are lower than those of the prior art, yet ensure the reliable operation of the so programed NMOS device of the read-only memory.

Furthermore, the method described allows programing by implant, without using the active area mask, so that programing can be performed in a rather advanced fabrication step, with the advantages in delivery times already described above.

Furthermore, the process according to the invention makes use of phases which employ already-known technologies, for which machines which are common in the electronics industry are used, so as to keep the production costs comparable with those of similar devices.

The invention thus conceived is susceptible to numerous modifications and variations, all of which are within the scope of the invention as defined in the appended claims. More in detail, though in the description reference was made to two specific embodiments of the method, the present invention is directed to cover any embodiment which implies a greater doping of the channel at the source junction with respect to the drain junction, so as to achieve a high threshold voltage and at the same time a high breakdown voltage.

Furthermore all the details may be replaced with other technically equivalent ones.

Where technical features mentioned in any claim are followed by reference signs, those reference signs have been included just for the sole purpose of increasing intelligibility of the claims and accordingly, such reference signs do not have any limiting effect on the scope of each element identified by way of example by such reference signs.

## Claims

1. A method for ion implant programming of NMOS read-only memories comprising a plurality of NMOS devices each having drain and source regions (12, 12', 19, 19') and a channel region (10', 10'') extending at least partially between said source and drain regions, said method comprising forming insulation field oxide regions (2) on a semiconductor body (1) of a first conductivity type, said field oxide regions (2) delimiting active areas of the NMOS devices, forming a thin gate oxide layer (3) on said semiconductor body (1) in said active areas, forming gate regions (4) on said gate oxide layer (3), selectively introducing dopant impurities in said substrate (1) for forming heavier doped regions (10) of said first conductivity type, and diffusing drain and source regions (12, 12', 19, 19') of the opposed conductivity type in said active regions laterally to said gate regions (4), characterized in that for programming NMOS devices with said thin gate oxide layer (3), after having formed said gate regions (4), a program masking step is carried out for depositing a programming mask (6) covering said semiconductor body (1) and having openings selectively facing said active areas at the source regions (12, 19) and at parts of said gate regions (4), adjacent to said source regions (12, 19), of some selected of said NMOS devices to be programmed in an OFF state, then performing said step of introducing dopant impurities for causing said channel regions (10', 10'') of the selected NMOS devices to be heavier doped only at the portions thereof adjacent to said source regions (12, 19) such that the threshold voltage can be increased or the gate oxide thickness can be decreased without reducing the breakdown voltage.

2. A method according to claim 1, characterized in that said step of introducing dopant impurities comprises a boron implant step.

3. A method according to claims 1 and 2, characterized by, after said step of introducing dopant impurities. a first N type impurities implant where said drain and source regions (19, 19') are to be formed, formation of oxide spacers (20) laterally to said gate regions (4), and second N type impurities implant at said drain and source regions (19, 19') for obtaining light drain doped devices.

## Patentansprüche

1. Verfahren zum Programmieren durch Ionen-Implantation von NMOS-Nurlesespeichern mit mehreren NMOS-Schaltkreisen mit jeweils Drain- und Source-Abschnitten (12, 12', 19, 19') und einem Kanalabschnitt (10', 10''), der sich mindestens teilweise zwischen den Source- und Drain-Abschnitten erstreckt, wobei das Verfahren die Schritte aufweist, Isolierfeldoxydabschnitte (2) auf einem Halbleiterkörper (1) einer ersten Leitfähigkeitsart auszubilden, wobei die Feldoxydabschnitte (2) die aktiven Bereiche der NMOS-Schaltkreise begrenzen, eine dünne Gate-Oxydschicht (3) auf dem Halbleiterkörper (1) in den aktiven Bereichen zu bilden, Gate-Abschnitte (4) auf der Gate-Oxydschicht (3) zu bilden, wahlweise Dotierungsverunreinigungen im Substrat (1) zur Ausbildung von stärker dotierten Abschnitten (10) der ersten Leitfähigkeitsart einzubringen und die Drain- und Source-Abschnitte (12, 12', 19, 19') der entgegengesetzten Leitfähigkeitsart in den aktiven Bereichen quer zu den Gate-Abschnitten (4) diffundieren zu lassen, dadurch gekennzeichnet, daß zur Programmierung der NMOS-Schaltkreise mit der dünnen Gate-Oxydschicht (3) nach Ausbildung der Gate-Abschnitte (4) ein Programmierungsmaskierungsschritt durchgeführt wird, um eine Programmierungsmaske (6) aufzubringen, die den Halbleiterkörper (1) bedeckt und Öffnungen besitzt, die wahlweise auf die aktiven Bereiche an den Source-Abschnitten (12, 19) und an den benachbart zu den Source-Abschnitten (12, 19) gelegenen Teilen der Gate-Abschnitte (4) von einigen ausgewählten, in einem AUS-Zustand zu programmierenden NMOS-Bauelementen gerichtet sind, anschließend den Schritt zur Einbringung der Dotierungsverunreinigungen durchzuführen, um die Kanalabschnitte (10', 10'') der ausgewählten NMOS-Bauelemente nur an deren benachbart zu den Source-Abschnitten (12, 19) gelegenen Abschnitten stärker zu dotieren, so daß die Schwellwertspannung erhöht werden kann oder die Gate-Oxyddicke ohne Reduzierung der Durchschlagspannung verringert werden kann.

2. Verfahren nach Anspruch 1, dadurch gekennzeichnet, daß der Schritt zur Einbringung von Dotierungsverunreinigungen einen Borimplantierungsschritt umfaßt.

3. Verfahren nach den Ansprüchen 1 und 2, gekennzeichnet durch die Schritte, nach dem Einbringen von Dotierungsverunreinigungen Verunreinigungen der ersten N-Art zu implantieren, wo die Drain- und Source-Abschnitte (19, 19') auszubilden sind, Oxydabstandselemente (20) seitlich zu den Gate-Abschnitten (4) auszubilden und Verunreinigungen der zweiten N-Art an den Drain- und Source-Abschnitten (19, 19') zu implantieren, um im Drain-Abschnitt leicht dotierte Bauelemente zu erhalten.

**Revendications**

1. Procédé de programmation par implantation ionique de mémoires mortes NMOS comprenant une pluralité de dispositifs NMOS ayant chacun des régions de drain et de source (12, 12', 19, 19') et une région de canal (10', 10'') s'étendant au moins partiellement entre lesdites régions de source et de drain, ledit procédé comprenant les étapes suivantes : former des régions d'isolation (2) d'oxyde de champ sur un substrat (11) d'un premier type de conductivité, lesdites régions d'oxyde de champ (2) délimitant des zones actives des dispositifs NMOS ; former une couche mince d'oxyde de grille (3) sur ledit substrat (1) dans lesdites zones actives ; former des régions de grille (4) sur ladite couche d'oxyde de grille (3) ; introduire sélectivement des impuretés de dopage dans ledit substrat (1) pour former des régions davantage dopées (10) dudit premier type de conductivité ; et diffuser des régions de drain et de source (12, 12', 19, 19') du type de conductivité opposé dans lesdites régions actives latéralement auxdites régions de grille (4) ; caractérisé en ce que pour programmer des dispositifs NMOS présentant ladite couche mince d'oxyde de grille (3), après avoir formé lesdites régions de grille (4), une étape de masquage de programmation est effectuée pour déposer un masque de programmation (6) couvrant ledit substrat (1) et présentant des ouvertures faisant face sélectivement auxdites régions actives au niveau des régions de source (12, 19) et au niveau de parties desdites régions de grille (4), adjacentes auxdites régions de source (12, 19), de dispositifs NMOS sélectionnés devant être programmés à l'état bloqué, pour effectuer ensuite ladite étape d'introduction d'impuretés de dopage pour provoquer lesdites régions de canal (10', 10'') des dispositifs NMOS sélectionnés à être davantage dopés seulement au niveau des parties adjacentes auxdites régions de source (12, 19), de manière que la tension de seuil peut être augmentée ou l'épaisseur de l'oxyde de grille peut être diminuée sans diminuer la tension de claquage.

2. Procédé selon la revendication 1, caractérisé en ce que ladite étape d'introduction d'impuretés de dopage comprend une étape d'implantation de bore.

3. Procédé selon les revendications 1 et 2, caractérisé par, après ladite étape d'introduction d'impuretés de dopage, une implantation d'un premier type N d'impuretés là où lesdites régions (19, 19'') de drain et de source doivent être formées, une formation d'espaceurs (20) d'oxyde latéralement par rapport auxdites régions de grille (4), et une implantation d'impuretés d'un deuxième type N au niveau desdites régions de drain et de source (19, 19') pour obtenir des dispositifs à drain faiblement dopé.

Fig.1

Fig.2

Fig.3

Fig.4

Fig.5